# EUROPEAN PATENT SPECIFICATION

(11) **EP 0 200 951 B1**
(45) Date of publication and mention of the grant of the patent: **01.12.1993**
(21) Application number: 86105006.0
(22) Date of filing: 11.04.1986
(51) Int. Cl.: H01L 21/306

(54) **Anisotropic silicon etching in fluorinated plasma**
Verfahren zum anisotropischen Ätzen von Silizium mittels eines fluorierten Plasmas
Procédé d'attaque anisotropique de silicium dans un plasma comportant des composés fluorés

(30) Priority: 06.05.1985 US 730988
(43) Date of publication of application: 17.12.1986
(73) Proprietor: International Business Machines Corporation, Armonk, N.Y. 10504 (US)
(72) Inventor: Chen, Lee, Poughkeepsie New York 12603 (US); Mathad, Gangadhara Swami, Poughkeepsie New York 12603 (US)
(74) Representative: Schäfer, Wolfgang, Dipl.-Ing.

(56) References cited:
- EP-A- 0 127 188
- US-A- 4 473 435
- US-A- 4 490 209
- INTERNATIONAL ELECTRON DEVICES MEETING TECHNICAL DIGEST, Washington, 7th - 9th December 1981, pages 578-581, IEEE, New York, US; R.H. BRUCE et al.: "High rate anisotropic etching"
- EXTENDED ABSTRACTS, vol. 84, no. 1, 6th - 11th May 1984, page 135, abstract no. 92, Pennington, New York, US; R. PINTO et al.: "The effect of dilution of SF6 with O2, H2, N2 and Ar in RIE"
- PLASMA CHEMISTRY AND PLASMA PROCESSING, vol. 4, no. 1, March 1984, pages 1-14, Plenum Publishing Corp., New York, US; R. D'AGOSTINO et al.: "Radiofrequency plasma decomposition of CnF2n+2-H2 and CF4-C2F4 mixtures during Si etching or fluoropolymer deposition"

## Description

The present invention relates to device fabrication such as LSI or VLSI semiconductor chips, and more particularly to plasma etch processes designed to define microscopic patterns in such devices.

Many dry etching processes for etching silicon are known, typically involving plasmas in the so-called reactive ion etch (RIE) regime of relatively low pressure, approximately 30-100 micrometers, and low power density, about .01 to .5 watt/cm². Recently, much attention has been directed in the semiconductor industry to the plasma etching using high pressure, 1 mbar and above, and high power density, 2 to 10 watt/cm², resulting in substantially higher etch rates than possible using an RIE process. International Electron Devices Meeting Technical Digest, Washington, 7th-9th December 1981, p. 578-581, IEEE, New York discloses high pressure etching of Si; a gas mixture of CF₄, C₂F₆ and Ar etched Si slowly (<0.1µm/min) whilst fast anisotropic etching of Si was achieved using Cl₂.

In plasma etch processes, two removal components contribute to form the resulting etch profile in the target film: a chemical component, due to the chemical reaction of the plasma generated species with the surface material to be removed, and a physical component, due to the momentum transfer of the charged particles formed in the plasma and accelerated through the sheath to the target material. Plasma etch processes carried out in the high pressure regime are distinguished by the much greater importance of the chemical component in etching than in the low pressure RIE processes.

In the conventional fluorinated gas chemistry, as exemplified by US-A-4,310,380 to Flamm et al., etching is isotropic in nature, with comparable lateral and vertical etch rates in silicon. In the disclosed process the chemical component of the readily dissociated NF₃ ambient is very strong, even in the low pressure RIE type process, where one would normally expect a greater vertical etch rate than lateral rate due to the strength of the physical bombardment. In a high pressure regime, such a gas chemistry will become even more isotropic. While isotropic etching is useful in some silicon etch steps, it is not desirable where deep etching of silicon (3 to 5 micrometers) of small dimensions is required, such as in isolation trench etching. In such a process, a trench is etched around a transistor or other device which is then filled with a dielectric material to electrically isolate the device. The trench cuts vertically through several layers of differently doped polysilicon or silicon. An etch plasma which uses chlorinated gases to control undercut will undercut each layer a different amount depending on that layer's reactivity with fluorine and chlorine. These and other problems are overcome by the present invention as given in claim 1.

One object of the present invention is to provide an improved plasma etching process for silicon, particularly when multiple silicon layers having different doping characteristics are present.

According to one embodiment of the invention, the etchant gas composition includes three major constituents: the etchant species, for example, NF₃ or SF₆; an inert gas, such as N₂; and a polymerizing gas such as CHF₃. Nitrogen trifluoride (NF₃) readily dissociates in a plasma releasing free fluorine and fluorine containing radicals in greater quantities than alternate fluorine sources. It is also much safer than ClF₃, BrF₃, or IF₃ which are potentially explosive gases not suitable in a manufacturing environment. In fact, the extremely rapid dissociation of NF₃ in a high pressure plasma proves to cause rather nonuniform etching without the dilution by an inert gas. Nitrogen was found to yield some what better uniformities than argon or helium.

The addition of a small amount of a polymerizing gas to the high pressure plasma gives the present process its anisotropic character. The choice of polymerizing gases is determined by the type of mask used. A fluorine containing gas is preferred for photoresist, aluminum or chromium masks, while a silicon dioxide mask will necessitate in addition a chlorine containing gas to the fluorine etchant mixture. In the plasma, the gas will form a polymer which is subsequently conformally deposited on the target surface. In a vertical direction, the polymer is etched away, leaving a polymer passivated sidewall. The sidewall is protected from lateral etching and undercutting of the silicon is thus eliminated. In the particular case of trench isolation processing, the etchant species does not attack the sidewall of the differently doped polysilicon and so there is no variable under-cut such as that encountered in processes using chlorinated gases to control anisotropy.
- FIG. 1: is a cross-sectional view in elevation of a high pressure single wafer reactor used to practice the process of present invention; and
- FIG. 2: is a cross-sectional view of a portion of an integrated circuit device etched in accordance with the present invention, specifically, for trench isolation.

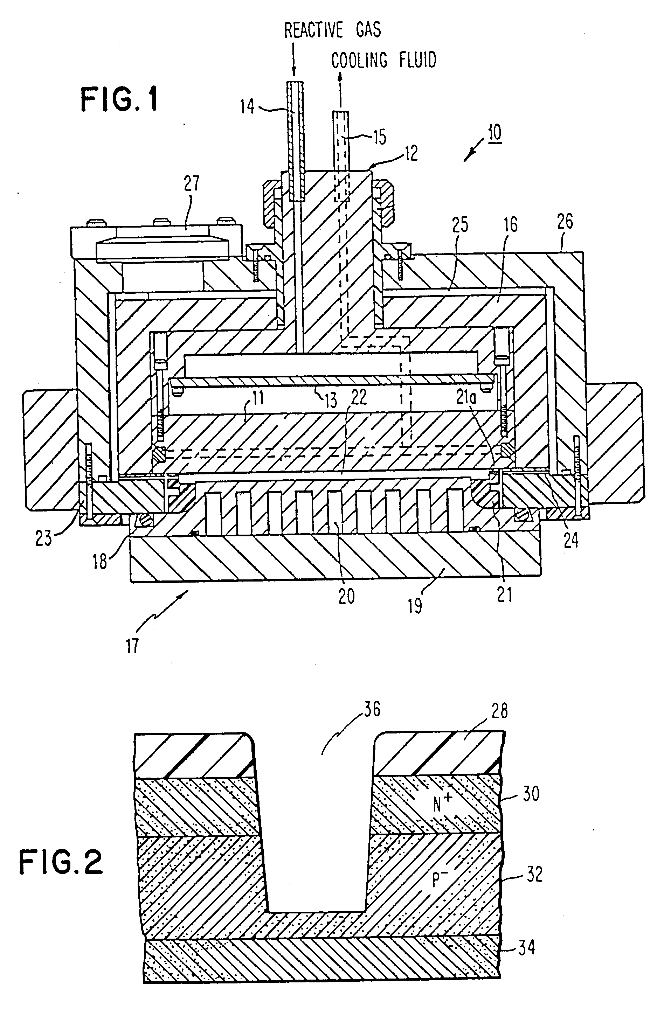

In accordance with the principles of the present invention, etching is performed in a high pressure, high plasma density single wafer reactor of the type shown in FIG. 1. The reactor is similar in design to that described in greater detail in the copending US-A-4 534 816, and assigned to the present assignee, which is incorporated herein by reference.

Referring now to the drawings, there is shown in FIG. 1 a single wafer reactor 10, wherein a circular, electrically grounded upper electrode 11 is attached to a cylindrical housing 12. Housing 12 has a gas distributing baffle 13, a reactive gas inlet 14, and a cooling fluid inlet (not shown) and outlet 15. This assembly is contained within an insulating housing 16. The lower electrode 17 includes a conductive upper section 18 and an insulating lower section 19. Upper section 18 includes cooling channels 20 and a raised portion surrounded by an insulating ring 21 having gas exhaust channels 21a. The spacing 22 between the upper 11 and lower 17 electrodes is set at approximately 4 mm. An insulating ring 23, which electrically isolates the two electrodes, is formed of conduits 24 for exhausting the gas from the inter-electrode spacing. These conduits 24 open into a gap 25 between inner housing 16 and outer housing 26. The reacted gases are exhausted from the system through a port 27.

FIG. 2 is a greatly enlarged cross-sectional representation of a portion of a silicon wafer showing a trench etched according to the principles of the present invention. A patterned mask layer 28, for example, photoresist, aluminum, chromium or silicon dioxide, is formed on the surface of a heavily n-doped layer 30 of polycrystalline silicon. The mask layer 28, of course, must be resistant to the etching gas mixture. Layer 30 overlies a lightly p-doped monocrystalline silicon layer 32 which is formed on a silicon wafer 34. According to one embodiment of the present invention, the unmasked areas of layers 30 and 32 are etched anisotropically to form a trench 36 having substantially vertical sidewalls. Trench 36 may typically have a width of about 5 micrometers.

Fluorine containing polymerizing gases such as CHF₃, C₂F₄, C₂F₆ and C₃F₈ have been found to be advantageous in etching silicon or doped polysilicon through photoresist, aluminum or chromium mask layers. It has been found that a silicon dioxide mask layer requires, in addition, an amount of a chlorine containing gas such as CCl₄, CFCl₃, CF₂Cl₂ or C₂HCl₃, the latter being a hydrogen containing freon.

It is to be understood that the specific sequence of doped or undoped layers are illustrative only, and that any sequence or number or layers of undoped polysilicon, doped polysilicon, and monocrystalline silicon may be etched utilizing the principles of this invention.

In accordance with a preferred embodiment of the present invention, a pressure of about 1 mbar is established in plasma reactor 10. The etchant gas is introduced at a total flow rate of about 24 s·cm³; 10 s·cm³ of NF₃, 10s·cm³ of N₂, and 4 s·cm³ of CHF₃. In the single wafer reactor, a power density of about 2 watts/cm² is generated at the wafer surface. The upper electrode 11 temperature is maintained at about 0 degrees C., and the temperature of the lower electrode at about -10 degrees C. The silicon wafer is partially masked and placed on the lower electrode 17. For the process conditions specified above, anisotropic etch rates of about 1.6 micrometers/min. have been observed.

The above example is illustrative only. More generally, etching can be carried out by selecting pressures, gas flows, and power densities in the ranges of 0.5 to 7 mbar, 10 to 100 s·cm³, and 1 to 10 watts/cm², respectively.

## Claims

1. A method of anisotropically etching a silicon body, comprising:
placing said silicon body in a high pressure gaseous plasma environment including a fluorine containing gaseous compound, an inert gas, and a polymer forming gas comprising a polymer forming gaseous compound, wherein said fluorine containing gaseous compound is selected from the group consisting of NF₃ and SF₆, and said polymer forming gaseous compound is selected from the group consisting of CHF₃, C₂F₄, C₂F₆ and C₃F₈.

2. The method of claim 1, wherein said silicon body has a patterned masking layer thereon.

3. The method of claim 1 or 2, wherein said silicon body to be etched comprises multiple layers of differently doped polysilicon and monocrystalline silicon.

4. The method of any one of the claims 1 to 3, wherein said gaseous plasma environment comprises a pressure of 0,5 to 7 mbar and a power density of 1 to 10 watts/cm² at the surface of said silicon body.

5. The method of any one of the claims 2 to 4, wherein said patterned masking layer is composed of silicon dioxide and said polymer forming gas in addition contains an amount of chlorine-containing gas.

## Patentansprüche

1. Verfahren zum anisotropen Ätzen eines Siliciumkörpers, das folgendes umfaßt:
Plazierung des Siliciumkörpers in einer gasförmigen Plasmaumgebung mit hohem Druck, die eine fluorhaltige, gasförmige Verbindung, ein Inertgas und ein polymerbildendes Gas, das eine polymerbildende, gasförmige Verbindung umfaßt, enthält, wobei die fluorhaltige, gasförmige Verbindung aus der aus NF₃ und SF₆ bestehenden Gruppe und die polymerbildende, gasförmige Verbindung aus der aus CHF₃, C₂F₄, C₂F₆ und C₃F₈ bestehenden Gruppe ausgewählt wird.

2. Verfahren gemäß Anspruch 1, wobei sich auf dem Siliciumkörper eine strukturierte Maskenschicht befindet.

3. Verfahren gemäß Anspruch 1 oder 2, wobei der zu ätzende Siliciumkörper aus mehreren Schichten aus unterschiedlich dotiertem Polysilicium und monokristallinem Silicium besteht.

4. Verfahren nach einem der Ansprüche 1 bis 3, wobei die gasförmige Plasmaumgebung an der Oberfläche des Siliciumkörpers einen Druck von 0,5 bis 7 mbar und eine Leistungsdichte von 1 bis 10 Watt/cm² umfaßt.

5. Verfahren nach einem der Ansprüche 2 bis 4, wobei die strukturierte Maskenschicht aus Siliciumdioxid besteht und das polymerbildende Gas zusätzlich chlorhaltiges Gas enthält.

## Revendications

1. Méthode pour attaquer anisotropiquement une corps de silicium; comprenant les étapes suivantes consistant à:
placer ledit corps de silicium dans un environnement de plasma gazeux haute-pression comprenant un composé gazeux contenant du fluor, un gaz inerte, et un gaz de polymérisation comprenant un composé gazeux de polymérisation, dans lequel ledit composé gazeux content du fluor est sélectionné dans un groupe comprenant le NF₃ et le SF₆ , et ledit composé gazeux de polymérisation est sélectionné dans un groupe comprenant le CHF₃, le C₂F₄, le C₂F₆ et le C₃F₈.

2. Méthode selon la revendication 1, dans laquelle une couche de masquage à motifs recouvre ledit corps de silicium.

3. Méthode selon la revendication 1 ou 2, dans laquelle ledit corps de silicium à attaquer est constitué de plusieurs couches de polysilicium et de silicium monocristallin ayant des caractéristiques de dopage différentes.

4. Méthode selon l'une quelconque des revendications 1 à 3, dans laquelle ledit environnement de plasma gazeux est caractérisé par une pression comprise entre 0,5 et 7 mbar et par une densité de puissance comprise entre 1 et 10 watts/cm² à la surface du dit corps de silicium.

5. Méthode selon l'une quelconque des revendications 2 à 4, dans laquelle ladite couche de masquage à motifs est composée de dioxyde de silicium et ledit gaz de polymérisation contient, de plus, une certaine quantité de gaz contenant du chlore.
